# EUROPEAN PATENT SPECIFICATION

(11) **EP 0 443 945 B1**
(45) Date of publication and mention of the grant of the patent: **14.12.1994**
(21) Application number: 91400448.6
(22) Date of filing: 19.02.1991
(51) Int. Cl.: H04N 7/01, H04N 7/13

(54) **Sampling rate converter**
Abtastratenumsetzer
Convertisseur de la fréquence d'échantillonnage

(30) Priority: 19.02.1990 JP 39010/90
(43) Date of publication of application: 28.08.1991
(73) Proprietor: SONY CORPORATION, Tokyo (JP)
(72) Inventor: Fujita, Tadao, Shinagawa-ku Tokyo (JP)
(74) Representative: Thévenet, Jean-Bruno

(56) References cited:
- EP-A- 0 305 864
- EP-A- 0 336 669
- DE-A- 3 304 006

## Description

### BACKGROUND OF THE INVENTION

This present invention relates to a sampling rate converter, and is suitably applied to a case where a sampling frequency of component digital video signals based on a D-1(625/50) format is converted to a sampling frequency corresponding to composite digital video signals based on a D-2 format, for example.

It has been known to use a sampling rate converter constituted by a digital filter for converting digital signals, obtained by sampling analog signals at a predetermined frequency, to an arbitrary sampling frequency.

Such a sampling rate converter is constituted by a high order oversampling filter to strictly observe the Nyquist frequency as a conversion characteristic of the transmission system.

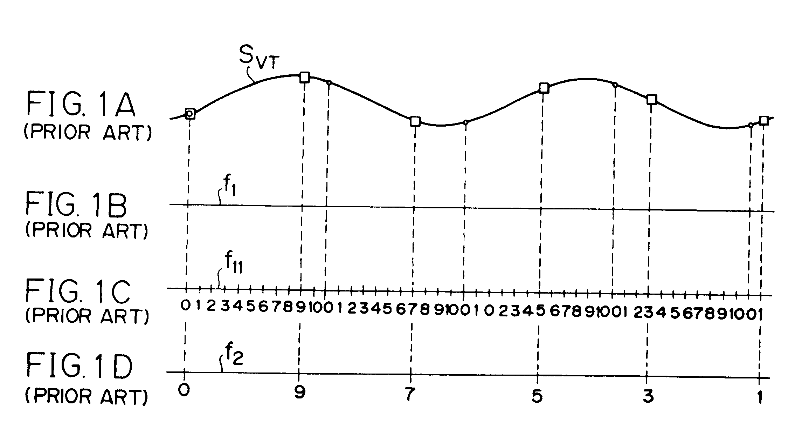

FIGS. 1A-1D, approximately illustrate the operation of a sampling rate converter constructed by an oversampling filter. In such an oversampling filter, input digital signals (indicated by character o in FIG-1A) are inputted to the oversampling filter, the input digital signals being provided by sampling imaginary analog signals S_{VT} as shown in FIG. 1A at a first sampling frequency f₁ (FIG. 1B).

Subsequently, the oversampling filter oversamples input digital signals at a frequency f₁₁ 11 times larger, as shown in FIG. 1C , and resamples them at a second sampling frequency f₂ (FIG. 1D) to obtain output digital signals. The latter have values indicated by characters □ in FIG.1A and are rate converted into frequency f₂.

When a sampling frequency of component digital video signals based on the D-1 (625/50), format as used in a digital video tape recorder (DVTR) is converted into a sampling frequency corresponding to PAL composite digital video signals based on the D-2(PAL) format, it is not possible to directly convert sampling frequency between digital video signals since the sampling frequency is rate converted from a frequency 13.5 MHz to a frequency 17.734475 MHz. It is thus necessary to build an oversampling filter having approximately a length of the order of about 16500.

Also, in the converse case where a sampling frequency of PAL composite digital video signals is converted into a sampling frequency corresponding to 625/50 component digital video signals, it is necessary to build an oversampling filter in the same circuit scale as the above described case since the sampling frequency is rate converted from a frequency 17.734475 MHz to a frequency 13.5 MHz. It is thus inevitable that the overall circuit scale becomes complicated and large.

To solve such a problem, a sampling rate converter has been proposed in which a oversampling filter of reduced circuit scale is built whereby the relationship of sampling frequencies of 13.5 MHz and 17.734475 MHz, between 625/50 component digital video signals and PAL composite digital video signals, are used to set an oversampling frequency, and to enter variable filter coefficients to one multiplier corresponding to a magnification of the oversampling to weight the sampling data.

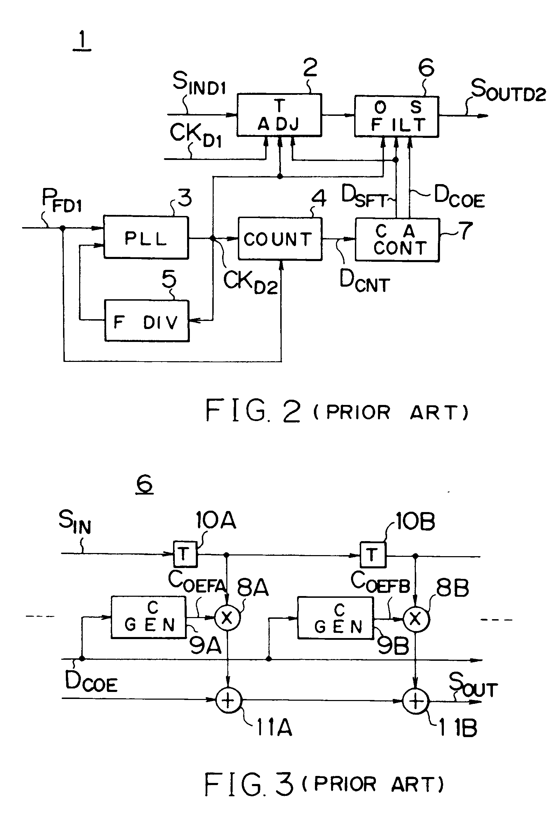

FIG. 2 illustrates a basic construction of a sampling rate converter 1 having changeable coefficients. In this example the sampling rate converter as shown in FIG. 2, converts a sampling frequency of 625/50 component digital video signals into a sampling frequency corresponding to PAL composite digital video signals, (for example, 625/50). Component digital video signals S_{IND1} and output clock signals CK_{D1} corresponding to the sampling frequency thereof are inputted to the timing adjusting circuit 2.

The timing adjusting circuit 2 outputs data of the 625/50 component digital video signals S_{IND1}, which is inputted at the rate of the clock signal CK_{D1} at the timing of the rate of the clock signal CK_{D2} so as to exchange the clock as well as control the timing of the data transference described below.

In addition to this, frame pulses P_{FD1} corresponding to one frame of 625/50 component digital video signals S_{IND1} are inputted to reset terminals of a phase locked loop (PLL) circuit 3 and a counter 4.

The output of PLL circuit 3 is fed back through a frequency divider 5 with a dividing ratio (= 1/709379) corresponding to the number of samples of one frame (= 709379) of PAL composite digital video signals.

This enables the PLL circuit 8 to correctly synchronize with frame pulses P_{FD1} of 625/50 component digital video signals, and the PLL circuit 3 generates output clock signals CK_{D2} corresponding to the sampling frequency of the PAL composite digital video signals and supplies them to a count input terminal of the counter 4, the timing adjusting circuit 2 and an oversampling filter 6.

The counter 4 is reset according to frame pulses P_{FD1}, and counts output clock signals CK_{D2}, inputted from the PLL circuit 3, at every frame. Consequently, count data D_{CNT} varying from zero to 709378 is sequentially sent to a coefficient address control circuit 7.

The coefficient address control circuit 7 generates coefficient address data D_{COE} according to the count data D_{CNT} to read coefficients C_{OEFA}, C_{OEFB}, ... from coefficient generating circuits 9A, 9B, ... which are ROM (read only memories), the coefficients C_{OEFA} , C_{OEFB}, ... are fed to multipliers 8A, 8B, ... which serve as weighting means of the oversampling filter 6, of which part is illustrated in FIG. 3.

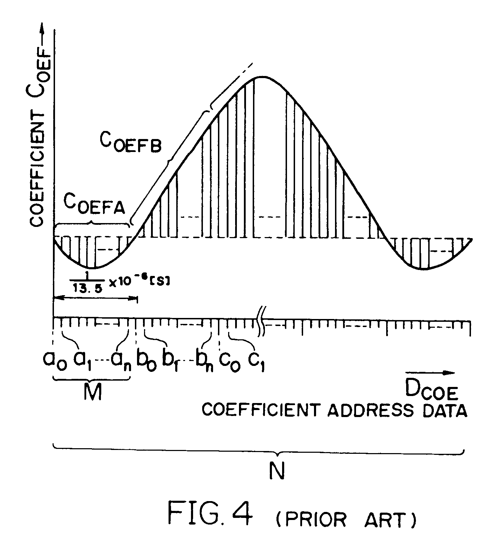

The relationship between coefficients C_{OEFA}, C_{OEFB}, ... supplied to the multipliers 8A, 8B, ... and the coefficient address data D_{COE} is illustrated schematically in FIG. 4. In FIG. 4, the Y-axis represents the coefficient C_{OEF} and the X-axis represents the coefficient address data D_{COE}. The X-axis can also be considered as a time axis. "N" is the order of the oversampling filter and is derived from the characteristic of the oversampling filter required. An impulse response characteristic of the oversampling filter is formed by N groups of the coefficient C_{OEF}. It should be noted that the impulse response characteristic illustrated in FIG-4, is schematic rather than realistic.

"M" represents the number of divisions between sampling points to the input signal S_{IND1}, that is a resolution capability, by which the oversampling frequency is decided. The groups of coefficient are divided by M groups so as to store them in the coefficient generating circuits 9A, 9B, ... , of which there are M/N. The addresses a₀... aₙ, b₀... bₙ are appointed with a coefficient address data D_{COE} generated at the rate of the clock signal CK_{D2} in the coefficient address control circuit so that the groups of coefficient C_{OEF} stored can be read out.

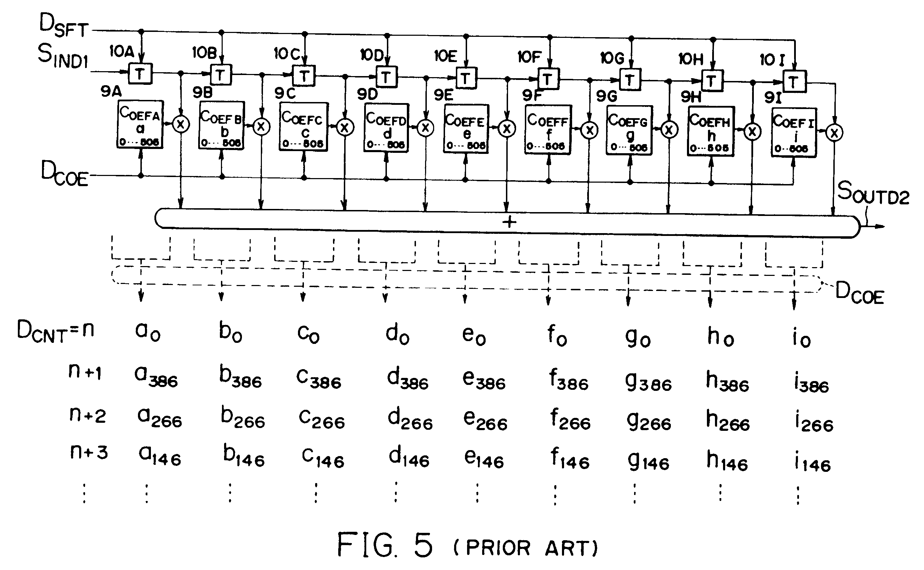

The relationship between the count data D_{CNT} and the address of the coefficient generating circuits 9A, 9B, ... appointed with the coefficient address data D_{COE} is illustrated in FIG. 5. In the case illustrated in FIG. 5, the oversampling filter is constructed with orders N = 4554, M = 506. The coefficients which form the impulse response characteristic of the oversampling filter are stored in sequence at the addresses from a₀, b₀, ... i₀ to a₅₀₅, b₅₀₅.The lower portion of FIG.5 illustrates the coefficient addresses D_{COE} which are generated at the timings of each of the count data D_{CNT}. In FIG. 5 , with the count data D_{CNT} exchanged in sequence n, n+1, n+2, ... at the rate of clock signal CK_{D2}, the coefficient address data D_{COE} is generated so that the addresses a₀ - a₅₀₅, b₀ - b₅₀₅, c₀ - c₅₀₅, ... are apointed in sequence [a₀, b₀, c₀, ...], [a₃₈₆, b₃₈₆, c₃₈₆, ...], [a₂₆₆, b₂₆₆, c₂₆₆, ...], ....

The appointment of the address in each of the coefficient generating circuits is performed on the basis of the relationship between the sampling period of 625/50 component digital video signal and the sampling period of the PAL composite digital video signal, so as to shift cyclicly by 386 addresses among addresses 0 - 505, as per the following equation.$\text{506 x} \frac{\text{13.5}}{\text{17.7}} \text{= 386}$

The coefficients C_{OEFA} - C_{OEFI} generated in the coefficient generating circuit 9A - 9I are multiplied by the output data in the multiplier. When the count data D_{CNT} takes on predetermined values, for instance D_{CNT} becoming D_{CNT} = n + 1 in FIG. 5, it is necessary to multiply a coefficient corresponding to D_{CNT} = n + 1 by the same data as the flip-flop output data multiplied at the timing D_{CNT} = n. In this case, the coefficient address control circuit 7 generates a shift control signal D_{SFT} to stop the data transference in the flip-flop circuits 10A - 10I(this is achieved by shifting one data block) so as to be able to multiply in the multiplier using the same flip-flop output data.

The shift control signal D_{SFT} also is applied to the timing adjusting circuit. This results in stopping the exchange of the clock according to the stopping of the operation of the data transference from the flip-flop circuits 10A - 10I, whereas the exchange of the clock continues in the timing adjusting circuit 2.

As described above, the timing adjustment circuit 2 adjusts the timing of inputted 625/50 component digital video signals S_{IND1} to send to the oversampling filter 6 - according to the output clock signals CK _{D1}- the output clock signals CK_{D2}, and the shift control data D_{SFT}.

The oversampling filter 6 performs oversampling by multiplying the thus inputted 625/50 component digital video signals S_{IND1} by coefficients C_{OEFA} , C_{OEFB} , ... according to the shift control data D_{SFT} and the coefficient address data D_{COE}, and provides outputs according to output clock signals CK_{D2}. In this manner, output digital video signals S_{OUTD2} are obtained by converting the sampling frequency of the 625/50 component digital video signals to a sampling frequency corresponding to the PAL composite digital video signals.

It is to be noted that in the oversampling filter 6 input digital signals S_{IN} are fed to a series circuit of flip-flops 10A, 10B, ... having a delay corresponding to output clock signals CK_{D2}. Delayed digital signals sent out from each of the flip-flops 10A, 10B, ... are inputted to subsequent flip-flops 10B, ... and to corresponding multipliers 8A, 8B,....

Predetermined coefficients C_{OEFA}, C_{OEFB}, ... described above are inputted from the coefficient generating circuits 9A, 9B, ... to respective multipliers 8A, 8B, ..., in order that the delayed digital signals can be mulitplied by respective coefficients C_{OEFA}, C_{OEFB}, ....

Results of the multiplication are inputted to each of adders 11A, 11B, ... for providing a total, and the result of this addition is output as digital video signals S_{OUT}.

The sampling rate converter 1 with such a construction has a large scale circuit configuration in which the counter 4 counts a value 0 to 709378. Also, the coefficient address control circuit 7 inevitably has a large scale circuit configuration for processing count data D_{CNT} from the counter 4. Consequently, there is a problem in that the sampling rate converter 1 becomes large sized.

### SUMMARY OF THE INVENTION

In view of the foregoing, an object of this invention is to provide a sampling rate converter which is capable of converting a sampling frequency of digital signals sampled at a first sampling frequency to a second sampling frequency, using a simple construction.

In accordance with a first aspect of this invention, there is provided a sampling rate converter 20 for converting a sampling frequency of digital signals sampled at a first sampling frequency to a second sampling frequency, the sampling rate converter including an oversampling filter 6 having coefficient generation means 9A, 9B for generating coefficients C_{OEFA}, C_{OEFB} to be provided to weighting means 8A, 8B according to coefficient addresses D_{COE1}. According to the present invention, the above problem is solved by : counting means 21 for counting output clocks CK_{D2} in a cyclic fashion; correction value generation means 22, 26 for generating a coefficient correction value D_{HC} in accordance with a number of counts of a maximum value C_{HC} and the periodicity of the first and second sampling frequencies, the number of counts of the maximum value being obtained by counting maximum value information S_{CO} sent from the counter means 21 every time the counter means counts to the maximum value; and coefficient address generation means 23, 24, 27 for generating the coefficient addresses D_{COE1} in accordance with the counted value D_{CNT1}, inputted from the counter means 21, and the coefficient correction value D_{HC} inputted from the correction value generation means 22, 26.

In this construction, output clocks CK_{D2} corresponding to the second sampling frequency are counted in the cyclic fashion from the initial value to the maximum value based on periodicity of the first and second sampling frequencies. Coefficient addresses D_{COE1} are generated in accordance to the resulting count value D_{CNT1} and the coefficient correction value D_{HC} in accordance with the number of counts of the maximum value C_{HC} and the periodicity of the first and second sampling frequencies, the number of the maximum value counts being the number of times of counting to a maximum value. The sampling frequency of digital signals sampled at the first sampling frequency is thus converted to the second sampling frequency with a simple construction based on counting from the initial value to the maximum value.

The nature, principle and utility of the invention will become more apparent from the following detailed description when read in conjunction with the accompanying drawings in which like parts are designated by like reference numerals or characters.

In the accompanying drawings:
FIG. 1 is a timing chart illustrating the oversampling operation according to prior art;
FIG. 2 is a block diagram showing the conventional sampling rate converter;
FIG. 3 is a block diagram showing part of the oversampling filter of FIG. 2;
FIG. 4 is a graph showing the relationship between the coefficient and the coefficient address data in the prior art;
FIG. 5 is a schematic diagram showing the relationship between the count data D_{CNT} and the coefficient address data D_{COE} in the prior art;
FIG. 6 is a block diagram showing one embodiment of the sampling rate converter according to this invention; and
FIG. 7 is a schematic diagram showing the shift of the coefficient address data with the correction according to the invention.

### DETAILED DESCRIPTION OF THE INVENTION

Preferred embodiments of this invention will be described with reference to the accompanying drawings:

### (1) Principle of the Embodiment

In a sampling rate converter of this embodiment, the sampling frequency of component digital video signals based on the D-1(625/50) format in a digital video tape recorder (DVTR) is converted to a sampling frequency corresponding to the PAL composite digital video signals based on the D-2(PAL) format.

In practice, the sampling frequency of component digital video signals based on the D-1(625/50) format is defined to be 13.5 MHz., and the number of samples for a line of digital video signals is hence 864. The total number of samples of one frame amounts to 540,000.

The sampling frequency of PAL composite digital video signals based on the D-2(PAL) format is 17.734475 MHz, which is four times the sub-carrier frequency f_{SC} calculated based on the following equation, provided the horizontal frequency fₕ is 15.625 KHz:${\text{f}}_{\text{SC}} \text{= (284 -} \frac{\text{1}}{\text{4}} {\text{)f}}_{\text{h}} \text{+} \frac{\text{50}}{\text{2}} \text{= 4.43361875 (MHz)}$

Accordingly, the number of samples per a line of digital video signals is 1135.0064, and the total number of samples of one frame is 709379.

As described, the ratio, in number, of samples for a line of the 625/50 component digital video signals over the PAL composite digital video signals is 864:1135.0064, and it is understood that the ratio does not have an appropriate integer relationship.

When a sampling frequency is converted using an oversampling filter with a sufficient length, the oversampling filter may be of a coefficient switch type construction. In this case, the combination of coefficients given to the oversampling filter must correspond to the phase between the pre-conversion sampling frequency and the post-conversion sampling frequency.

As already described, there is no relatively small integer ratio between the pre-conversion sampling frequency and the post-conversion sampling frequency, and it is hence necessary to count sampling points for a frame so as to generate a coefficient corresponding to the count value.

The sampling cycle of the 625/50 component digital video signals is computed from the following equation:$\frac{\text{1}}{\text{13.5 (MHz)}} \text{= 74.074074 (nsec)}$
The sampling cycle of the PAL composite digital video signals is computed from the following equation:$\frac{\text{1}}{\text{17.734475 (MHz)}} \text{= 56.38734724 (nsec)}$

By detecting the time difference between the sampling point corresponding to the sampling frequency of 625/50 component digital video signals and the sampling point corresponding to the sampling frequency of PAL composite digital video signals from the top of a frame, the number of samples of the 625/50 component digital video signals becomes a value given by the equation below, at a time point of 423 samples of PAL composite digital video signals when counted from the top of the frame:$\frac{\text{56.38734724 (nsec) x 423}}{\text{74.074074 (nsec)}} \text{= 321.9999464}$
the sampling points of both become closer in timing.

Sampling points of both which correspond to the sampling cycles of 625/50 component digital video signals and PAL composite digital video signals become closer every multiple of 423 sample points at the sampling cycle of PAL composite digital video signals.

In this embodiment, coefficient addresses and the data shift control are held between 423 sample points with reference to the sampling cycle of the PAL composite digital video signals. In this manner, correction of time given by the equation below is performed every 423 sample points at the sampling cycle of the PAL composite digital video signals. The corresponding equation can be expressed as :$\text{56.38734724 (nsec) x 423} \text{- 74.074074 (nsec) x 322} \text{= - 0.00396796 (nsec)}$
In phase shifting and generation of coefficients, the above-described correction is carried out by providing a counter which counts sampling within a small range between 423 sample points. This enables the sampling frequency to be converted at a high accuracy with a simple construction.

### (2) Sampling Rate Converter of the Embodiment

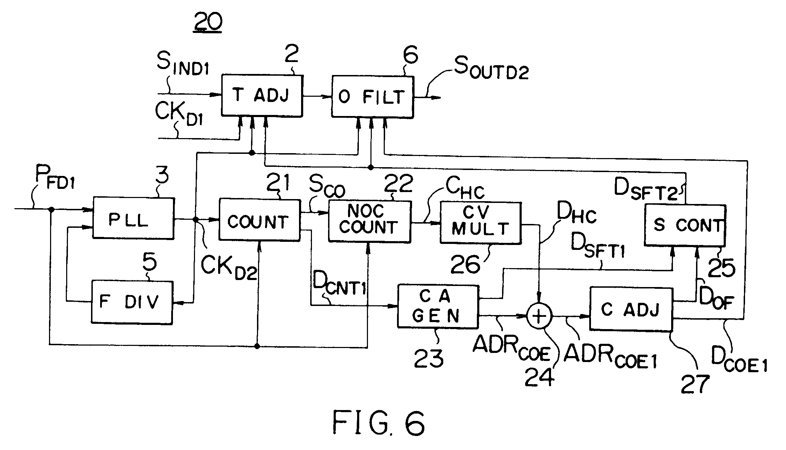

In FIG. 6, in which corresponding parts of FIG. 2 are given the same reference numerals, 20 generally designates a sampling rate converter which converts a sampling frequency of 625/50 component digital video signals to a sampling frequency according to PAL composite digital video signals, for example. In this embodiment, frame pulses P_{FD1} which correspond to every one frame of 625/50 component digital video signals S_{IND1} are inputted to a PLL circuit 3, a reset input terminal of a counter 21, and a reset terminal of a number-of-corrections counter 22.

The counter 21 is adopted in place of the conventional counter 4 . It counts to 709378 and is designed to count output clock signals CK_{D2} in a cyclic manner from zero to 422 on the basis of the principle stated in connection with the equations (3) to (6) during one frame of 625/50 component digital video signals S_{IND1}.

The counter 21 thus counts output clock signals CK_{D2} during one frame. The counter 21 sends resulting count data D_{CNT}, which goes from zero to 422 to a coefficient address generation circuit 23 . It also sends a carry signal S_{CO}, which is generated every time the counted value exceeds 422, to the correction frequency counter 22.

The coefficient address generation circuit 23 generates an coefficient address ADR_{COE} and shift data D_{SFT1} (this signal has the same function as the shift control signal D_{SFT}, i.e. a data transfer function and a clock exchange stopping function) in response to the inputted count data D_{CNT1}, and sends them to an adder 24 and a shift control circuit 25, respectively.

During one frame, the number-of-corrections counter 22 counts inputted carry signals S_{CO} to generate number-of-corrections data C_{HC}, which is sent to a corrected value multiplier 26.

The corrected value multiplier 26 calculates number-of-corrections data C_{HC} by multiplying the correction value (= 0.00396795 (nsec)) described in connection with the equation (6) with the number-of-corrections data C_{HC}, the corrected value data D_{HC} corresponding to correction of the coefficient address ADR_{COE} based on the number of corrections. The corrected value data D_{HC} is fed to the adder 24.

The adder 24 adds the coefficient address ADR_{COE} and the corrected value data D_{HC} to produce a corrected coefficient address ADR_{COE1}, which is provided to a coefficient adjusting circuit 27.

On the basis of the corrected coefficient address ADR_{COE1}, the coefficient adjusting circuit 27 generates coefficient address data D_{COE1} and sends it to coefficient generating circuits 9A, 9B, ... of the oversampling filter 6.

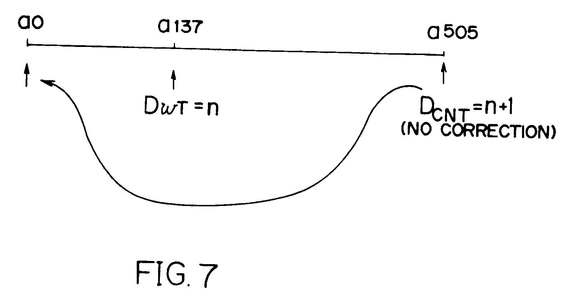

Moreover, the coefficient adjusting circuit 27 detects whether or not the coefficient address ADR_{COE1} is in overflow by comparison with the coefficient address ADR_{COE}, before correction, so as to send the resultant to the shift control circuit 25 as a overflow data D_{OF}. This overflow can be understood as follows. In FIG. 7, when the count data D_{CNT} is D_{CNT} = n the address a₁₃₇ is appointed as the address of the coefficient generating circuit. Subsequently, when the count data D_{CNT} becomes D_{CNT} = n + 1 the address a₀ is appointed by means of correction. In contrast, when the count data D_{CNT} becomes D_{CNT} = n + 1, the address a₅₀₅ is appointed, unless the address moves by means of correction.

The overflow occurs when the address exceeds a round address where the accesses of a round address is from a₀ to a₅₀₅. If such an overflow occurs, it is necessary to process as follows. Let it be assumed that there is an address relationship as in FIG.7.The output data of the flip-flop circuit 10A to be multiplied by the coefficient having the address a₀ needs to transfer data afresh by one clock, unless that data is to stop the transfer of the data to be multiplied by the coefficient. The operation "stop of data transference" and "stop of clock exchange" described above effectively cause such a stop.

The shift control circuit 25 detects whether or not there is need for "stop of data transference" and "stop of clock exchange". It sends the resultant signals as shift control signals S_{SFT2} to the timing adjusting circuit 2 and the oversampling filter 6.

Consequently, the timing adjusting circuit 2 controls the timing of the sending of 625/50 component digital video signals S_{IND1} to the oversampling filter 6 according to the output clock signals CK_{D1}, the output clock signals CK_{D2}, and the shift control data D_{SFT2}.

The oversampling filter 6 performs oversampling by multiplying the 625/50 component digital video signals S_{IND1} thus inputted by coefficients C_{OEFA}, C_{OEFB}, ... according to the shift control data D_{SFT2} and the coefficient address data D_{COE1}, and conducts resampling according to the output clock signals CK_{D2} and outputs the resultant data. In this manner, output digital video signals S_{OUTD2} which are produced by converting the sampling frequency of 625/50 component digital video signals to the sampling frequency of PAL composite digital video signals are obtained.

The oversampling filter 6 has coefficients equal in number to 505 times the oversampling frequency, and hence has a resolution of 1/505. In fact, the correction (= 0.00396795 (nsec)) stated about the equation (6) is 0.027068 times as large as the resolution. This value means that correction is carried out 45 times (that is, 0.178 (nsec)) at the trailing and of one frame. To do this, the counter 21 and the number-of-corrections counter 22 are controlled to be placed in initialized states by resetting them every frame.

According to the foregoing construction, sampling points are sequentially counted in a small range of 423 sampling points, and the predetermined correction is carried out every 423 sampling points. The sampling rate converter 20 is realized so that it enables the counter circuit to be built using a simple circuit construction which counts from zero to 422, and which is capable of converting a sampling frequency of 625/50 component digital video signals to a sampling frequency according to PAL composite digital video signals, at a high accuracy.

Moreover, according to the foregoing construction, the coefficient address generation circuit 23 is also built with a simple circuit construction by constructing the counter 21 with a simple circuit construction which counts zero to 422. A sampling rate converter is thus realized which is capable of reducing in circuit scale to about 1/1677 of the conventional sampling rate converter 1 (FIG. 2), resulting in a remarkable reduction in overall scale.

### (3) Other Embodiments

(3-1) In the embodiment above, a case where a sampling frequency of 625/50 component digital video signals is converted to a sampling frequency according to PAL composite digital video signals is stated but this invention is not limited to this. The invention can be suitably applied to a case where a sampling frequency of PAL composite digital video signals is converted to a sampling frequency according to 625/50 component digital video signals.
   It is to be understood that, in this case, an effect similar to that of the preceding embodiment will be achieved by adding the correction (= 0.00396795 (nsec)) described about the equation (6) every 322 sampling points of a sampling cycle of 625/50 component digital video signals according to the principle of the invention with reference to the equations (3) to (5).
(3-2). The preceding embodiments concern cases where a sampling frequency of PAL composite digital video signals or 625/50 component digital video signals is converted to a sampling frequency according to 625/50 component digital video signals or PAL composite digital video signals. However, the invention may also be suitably applied to various cases where a sampling frequency of digital signals is converted to a new sampling frequency which does not have a simple relationship integer ratio with the sampling frequency.
(3-3) In the preceding embodiments, a case where a range among every 423 sampling points of a sampling cycle of PAL composite digital video signal is counted is stated, but the invention is not limited to this. The invention can be suitably applied to a case where a range among every sampling points being integer times as many as 423 is counted.

## Claims

1. A sampling rate converter for converting a sampling frequency of digital signals sampled at a first sampling frequency to a second sampling frequency, including an oversampling filter having coefficient generation means for generating coefficients to be provided to weighting means according to coefficient addresses, characterized in that it comprises :
counting means for counting output clocks in a cyclic fashion from an initial value to a maximum value based on the periodicity of the first and second sampling frequencies, the output clocks corresponding to the second sampling frequency;
correction value generation means for generating a coefficient correction value in accordance with a number of counts of the maximum value and the periodicity of the first and second sampling frequencies, the number of the maximum value counts being obtained by counting maximum value information sent from the counter means every time the counter means counts to the maximum value; and
coefficient address generation means for generating the coefficient addresses in accordance with the counted value, inputted from the counter means, and the coefficient correction value inputted from the correction value generation means.

2. A sampling rate converter according to claim 1, wherein said correction value generation means comprises:
means for detecting the number of correction times, for detecting the number of times a correction occurs during one frame period, based on said maximum value information obtained from an output of said counting means;
multiplication means for multiplying an output of said correction detection means by a correction value to generate said coefficient correction value.

3. A sampling rate converter according to claim 1, wherein said coefficient address generation means comprises:
coefficient address generating means for generating a coefficient address and shift data based on said count value obtained from an output of said counting means;
addition means for adding said coefficient address and said correction value;
coefficient adjusting means for generating said coefficient adress data based on output data of said addition means, and for detecting said coefficient address data; delayed by one cycle; which is outputted as overflow data;
shift control means for generating said shift control signal based on said shift data and said overflow data.

4. A sampling rate converter according to claim 2, wherein said correction detection means is reset with counting means by a signal representing a frame period in connection with said first sampling frequency.

## Patentansprüche

1. Abtastratenumsetzer zum Umsetzen der Abtastfrequenz von mit einer ersten Abtastfrequenz abgetasteten digitalen Signalen in eine zweite Abtastfrequenz, der mit einem Überabstastfilter (Oversamplingfilter) ausgestattet ist, das eine Koeffizienten-Generatoreinrichtung zur Erzeugung von Koeffizienten aufweist, die nach Maßgabe von Koeffizientenadressen einer Gewichtungseinrichtung zuzuführen sind,
**gekennzeichnet durch**
eine Zähleinrichtung zum zyklischen Abzählen von der zweiten Abtastfrequenz entsprechenden Ausgangstakten von einem Anfangswert bis zu einem Maximalwert auf der Basis der Periodizität der ersten und der zweiten Abtastfrequenz,
eine Korrekturwert-Generatoreinrichtung zur Erzeugung eines Koeffizienten-Korrekturwerts in Abhängigkeit von der Anzahl der Zählungen des Maximalwerts und von der Periodizität der ersten und der zweiten Abtastfrequenz, wobei die Anzahl der Zählungen des Maximalwerts durch Zählen der Maximalwertinformation gewonnen wird, die die Zähleinrichtung jedesmal aussendet, wenn sie bis zum Maximalwert zählt,
und eine Koeffizientenadressen-Generatoreinrichtung zur Erzeugung der Koeffizientenadressen in Abhängigkeit von dem von der Zähleinrichtung eingegebenen Zählwert und dem von der Korrekturwert-Generatoreinrichtung eingegebenen Korrekturwert.

2. Abtastratenumsetzer nach Anspruch 1, bei dem die Korrekturwert-Generatoreinrichtung aufweist:
eine Korrektur-Detektoreinrichtung, die auf der Basis der aus dem Ausgangssignal der Zähleinrichtung gewonnenen Maximalwertinformation die Anzahl der Korrekturvorgänge während einer Vollbildperiode detektiert,
und eine Multipliziereinrichtung zum Multiplizieren des Ausgangssignals der Korrektur-Detektoreinrichtung mit einem Korrekturwert zur Erzeugung des genannten Koeffizientenkorrekturwerts.

3. Abtastratenumsetzer nach Anspruch 1, bei dem die Koeffizientenadressen-Generatoreinrichtung aufweist:
eine Koeffizientenadressen-Generatoreinrichtung zur Erzeugung einer Koeffizientenadresse und von Verschiebungsdaten auf der Basis des aus dem Ausgangssignal der Zähleinrichtung gewonnenen Zählwerts,
eine Addiereinrichtung zum Addieren der Koeffizientenadressen und des Korrekturwerts,
eine Koeffizientenjustiereinrichtung zur Erzeugung der Koeffizientenadressendaten auf der Basis der Ausgangsdaten der Addiereinrichtung und zum Detektieren der um einen Zyklus verzögerten Koeffizientenadressendaten, die als Überlaufdaten ausgegeben werden,
und eine Verschiebungssteuereinrichtung zur Erzeugung eines Verschiebungssteuersignals auf der Basis der genannten Verschiebungsdaten und der Überlaufdaten.

4. Abtastratenumsetzer nach Anspruch 2, bei dem die Korrektur-Detektoreinrichtung mit der Zähleinrichtung durch ein Signal zurückgesetzt wird, das in Verbindung mit der ersten Abtastfrequenz eine Vollbildperiode repräsentiert.

## Revendications

1. Convertisseur de cadence d'échantillonnage servant à convertir la fréquence d'échantillonnage de signaux numériques échantillonnés à une première fréquence d'échantillonnage en une deuxième fréquence d'échantillonnage, qui comporte un filtre de suréchantillonnage possédant des moyens générateurs de coefficient servant à produire des coefficients qui doivent être fournis à des moyens de pondération en fonction d'adresses de coefficient, caractérisé en ce qu'il comprend :
un moyen de comptage servant à compter des signaux d'horloge de sortie de façon cyclique, depuis une valeur initiale jusqu'à une valeur maximale, sur la base de la périodicité des première et deuxième fréquences d'échantillonnage, les signaux d'horloge de sortie correspondant à la deuxième fréquence d'échantillonnage ;
un moyen générateur de valeur de correction servant à produire une valeur de correction de coefficient en fonction du nombre de comptages de la valeur maximale et de la périodicité des première et deuxième fréquences d'échantillonnage, le nombre de comptages de la valeur maximale étant obtenu par comptage d'une information de valeur maximale envoyée par le moyen compteur à chaque fois que le moyen compteur compte la valeur maximale ; et
des moyens générateurs d'adresse de coefficient servant à produire les adresses de coefficient en fonction de la valeur comptée, fournie par le moyen compteur, et de la valeur de correction de coefficient fournie par le moyen générateur de valeur de correction.

2. Convertisseur de cadence d'échantillonnage selon la revendication 1, où le moyen générateur de valeur de correction comprend :
un moyen servant à déterminer le nombre de corrections, afin de déterminer le nombre de fois qu'une correction a eu lieu au cours d'une période d'une image complète, sur la base de ladite information de valeur maximale obtenue à partir d'un signal de sortie dudit moyen compteur ;
un moyen de multiplication servant à multiplier le signal de sortie dudit moyen de détection de correction par une valeur de correction, pour produire ladite valeur de correction de coefficient.

3. Convertisseur de cadence d'échantillonnage selon la revendication 1, où ledit moyen générateur d'adresse de coefficient comprend :
un moyen générateur d'adresse de coefficient servant à produire une adresse de coefficient et des données de décalage sur la base de ladite valeur de comptage obtenue à partir du signal de sortie dudit moyen compteur ;
un moyen d'addition servant à additionner ladite adresse de coefficient et ladite valeur de correction ;
un moyen d'ajustement de coefficient servant à produire ladite donnée d'adresse de coefficient sur la base des données de sortie dudit moyen d'addition, et à déterminer ladite donnée d'adresse de coefficient, retardée d'un cycle, qui est délivrée en sortie au titre de donnée de débordement ;
un moyen de commande de décalage servant à produire ledit signal de commande de décalage sur la base de ladite donnée de décalage et de ladite donnée de débordement.

4. Convertisseur de cadence d'échantillonnage selon la revendication 2, où ledit moyen de détermination de correction est repositionné avec le moyen compteur par un signal représentant une période d'image complète en relation avec ladite première fréquence d'échantillonnage.
